Europäisches Patentamt

European Patent Office

Office européen des brevets

(19)

(11) Publication number: **0 146 463**
**B1**

(12) **EUROPEAN PATENT SPECIFICATION**

(45) Date of publication of patent specification: 23.11.88

(51) Int. Cl.⁴: **H 05 K 7/10**

(21) Application number: 84402507.2

(22) Date of filing: 06.12.84

(54) Compliant lead frame for surface mount semiconductor packages.

(30) Priority: 06.12.83 US 558459

(43) Date of publication of application:
26.06.85 Bulletin 85/26

(45) Publication of the grant of the patent:
23.11.88 Bulletin 88/47

(84) Designated Contracting States:
DE FR GB IT NL

(56) References cited:
GB-A-2 115 220
US-A-4 340 266
US-A-4 449 165

IBM TECHNICHAL DISCLOSURE BULLETIN,
vol. 23, no. 12, May 1981, page 5352, New York,
US; I. FEINBERG et al.: "High performance
single-chip module"

(73) Proprietor: FAIRCHILD SEMICONDUCTOR
CORPORATION
10400 Ridgeview Court P.O. Box 1500
Cupertino, California 95014 (US)

(72) Inventor: Phy, William S.
25616 Moody Road
Los Altos Hills California 94022 (US)

(74) Representative: Dipl.-Ing. H. Marsch Dipl.-Ing. K.
Sparing Dipl.-Phys.Dr. W.H. Röhl Patentanwälte
Rethelstrasse 123 Postfach 14 02 68
D-4000 Düsseldorf (DE)

## Description

The present invention relates to integrated circuit packages, and more specifically to a lead frame having terminals that connect an integrated circuit to a printed circuit board with a high degree of compliance to thereby withstand mechanical stress due to thermal changes.

In the mounting of an integrated circuit package on a printed circuit board, or similar such support surface, it is important that the means which physically and electrically interconnect these two structures provide a certain amount of compliance to account for differences in the expansion of the two structures under changing thermal conditions. If sufficient compliance is not provided, the mechanical stress which results when one of the two structures expands or contracts more than the other can lead to a failure of the bond between the two.

The achievement of adequate compliance between the integrated circuit package and the printed circuit board cannot be achieved by merely matching the coefficient of expansion of these two structures. While a perfect thermal expansion coefficient match between the package and the board could assure substantially reliable interconnection when the board and package are subjected to thermal cycling at a relatively low frequency, the bond can nevertheless fail during higher frequency power cycling. Among the factors which can contribute to such failure are the difference in the effective specific heats of the semiconductor package and the printed circuit board, and the greater thermal radiating area of the board. In other words, because of the greater surface area of the board, it can dissipate heat more rapidly than the semiconductor package and thus may not increase in temperature in the area of the package/board bond as quickly as the package itself, leading to different rates of expansion. This difference in expansion in turn leads to stress in the area of the bond.

This stress must be capable of being absorbed in the bonding media and in the individual elements which make up the total circuit assembly. The most practical means for absorbing this stress is with a compliant interface between the semiconductor package and the printed circuit board. The degree of compliance which this interface must possess should be such that the elastic limits of the various components and the bonding media are not exceeded under extreme conditions.

From US-A-4340266 there is known a lead frame for providing compliant mechanical and electrical connections between a semiconductor package and a support surface, said lead frame comprising a series of adjacent terminal elements each of which includes two spaced mounting legs interconnected by a resilient intermediate section and said lead frame further comprising a portion of a plate stock, said portion being respectively interposed between and connected to the terminal elements in said series so as to form an aligned strip of terminal elements.

Of the presently available types of semiconductor packages, the peripheral leads that can be found on leaded chip carriers and formed lead flat packs provide such compliance to a limited degree. However, these lead arrangements are not suitable for use in array type semiconductor packages, wherein the attachment regions are arranged in a matrix pattern across one surface of the enclosure, rather than merely along the peripheral edges thereof.

Array type packages generally fall into one of three categories: the pin-grid, the pad-grid and the open-via. Of these three types, only the pin-grid arrangement provides any degree of compliance between the semiconductor package and the printed circuit board. However, this design requires a through-hole attachment, with which other limitations are associated. For example, this type of attachment poses alignment problems with respect to the board layers and the bonding pads of the package.

The pad-grid and open-via types of packages utilize a surface attachment rather than a through-hole attachment, which obviates these alignment problems. However, these types of packages, and more specifically the surface mounting arrangement associated with these packages, does not provide the required degree of compliance.

## BRIEF STATEMENT OF THE INVENTION

Accordingly, it is the object of the present invention to provide a surface mounting arrangement that is suited for use on array types of integrated circuit packages and which provides a high degree of compliance for absorbing the mechanical stress induced by thermal changes. In accordance with the present invention as claimed, this object is achieved with a lead frame that comprises a series of individual terminal elements that are connected in a strip form by means of break tabs disposed between adjacent elements. Each terminal element is appropriately shaped to provide two spaced, generally parallel mounting surfaces that are connected to one another by means of an integral intermediate section. While the terminal elements are interconnected in strip form, one of the mounting surfaces of each element can be bonded, for example brazed, to an associated attachment region on the semiconductor substrate. After all of the terminals of the strip have been so bonded, the break tabs between adjacent terminals can be removed to thereby separate the terminals from one another. The package which then results contains discrete compliant terminals which are suitable for subsequent surface attachment to the printed circuit board.

The lead frame can be constructed using conventional stamping tool technology. Furthermore, it can be selectively scored at desired lengths so as to provide individual strips having a predetermined number of terminals. The arrangement of the terminals in a linear strip form easily lends itself to continuous strip fabrication of the lead frame.

Further details and advantages of the invention will be apparent from the following description of the preferred embodiments of the invention illustrated in the accompanying drawings.

## BRIEF DESCRIPTION OF THE DRAWINGS

Figure 1 is a perspective view of a lead frame strip embodying the principles of the present invention;

Figure 2 is an end-view of the lead frame strip of Figure 1;

Figure 3 is a top-view of the lead frame strip of Figure 1;

Figure 4 is a side view of the lead frame strip of Figure 1;

Figure 5 is an end view of a second embodiment of a lead frame strip;

Figure 6 is an end view of a third embodiment of a lead frame strip;

Figure 7 is a perspective view of a semiconductor package during the processing step in which the terminal elements are attached to the package; and

Figure 8 is a perspective view of a fourth embodiment of a terminal strip.

## DESCRIPTION OF THE ILLUSTRATED EMBODIMENTS

In the following description of preferred embodiments of the invention illustrated in the accompanying drawings, particular reference is made to the use of the invention in connection with an array type semiconductor package, since this is one application for which the invention is particularly suited.

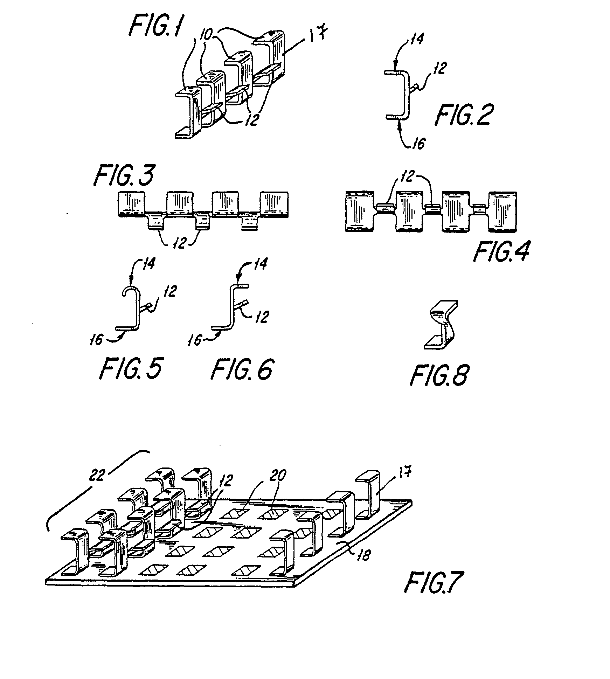

Referring generally to Figures 1-4, and more specifically to Figure 1, a compliant lead frame for surface mount semiconductor packages comprises a series of terminal elements 10 that are aligned and connected to one another in a spaced, side-by-side arrangement to form a strip comprised of a desired number of terminals. The terminals in the strip are interconnected by means of break tabs 12, one of which is connected between each two adjacent terminals in the strip.

As best shown in Figure 2, each terminal element 10 can be a C shaped member that provides two spaced, generally parallel mounting surfaces 14 and 16 which respectively comprise the two legs of the member. These two legs are interconnected by means of a compliant, i.e. resilient, central section 17, with the two legs and the central section preferably being integrally formed from a single piece of conductive material. The break tabs 12 which connect the various terminal elements to form the strip are attached to the central section of the C-shaped member and oriented at an angle thereto. Of course, rather than being located at approximately the middle of the central section 17, as shown in Figure 2, the break tabs can be connected to the terminal elements anywhere along their length.

As shown in Figures 5 and 6, configurations other than the C shape illustrated in Figure 2 can be used for the terminal elements. For example, the terminal element could be formed into an inverted J shape, as shown in Figure 5, or an essentially Z shape as shown in Figure 6. Basically, any shape which provides two spaced and compliantly interconnected mounting surfaces for the semiconductor package and the printed circuit board, respectively, can be utilized for the terminal elements.

Advantageously, the terminal elements 10 and break tabs 12 that form the lead frame strip can be integral with one another. In the preferred embodiment of the invention, the lead frame is formed from a single strip of an appropriate metal, for example, Kovar®, Alloy 42 or copper. This strip of metal can be suitably stamped and bent, using conventional technology, to form the terminal elements and the interposing break tabs. Preferably, the lead frame strip is scored at appropriate locations to enable a long strip to be segmented into several short strips each containing a number of terminal elements corresponding to the number of attachment sites in a row on the semiconductor package. For example, the scoring can be provided on each side of each break tab, not only to facilitate the segmenting of the long strip into several short strips, but also to enable the break tabs to be more easily removed from the strip once the terminal elements have been attached to the semiconductor package.

Referring to Figure 7, an array type semiconductor package 18 includes bonding sites 20 that are arranged in a matrix pattern on one surface of the package. Attachment of the compliant terminals to the package is carried out while the terminals are present in the strip form shown in Figure 1. More specifically, a strip 22 containing an appropriate number of terminals (four in the illustrated embodiment) is placed in contact with the package 18 so that one of the mounting surfaces 14 or 16 of each terminal in the strip engages each of the bonding sites 20 in a row of the matrix pattern. While in such an engagement, the terminals are bonded to the sites, for example by means of brazing, ultrasonic bonding, thermal compression or any other suitable technique. Once the bonding is completed and the lead frame strips are thereby suitably attached to the package, the break tabs 12 are removed from the strips, for example by twisting them about the longitudinal axis of each strip to break their connection to the terminal elements. With the break tabs removed, the resulting structure comprises a series of discrete terminals that are ready for surface attachment to the printed circuit board, as illustrated at the rightmost row of terminals on the semiconductor package of Figure 7.

Due to the configuration of the terminals which provide two spaced mounting surfaces that are integrally interconnected, the interface between the semiconductor package and the printed circuit board has a high degree of compliance which can withstand and absorb substantial stresses which may be generated due to differences in thermal expansion of the semiconductor and the printed circuit board. Most of the compliance is available along two axes, i.e., within the plane of the paper with reference to Figures 2, 5, and 6. Since the stress which is generated is omnidirectional, it may be desirable to provide added compliance along the third axis. In such a case, greater compliance can be provided by rotating one of the legs of the terminal element 10 relative to the other, so as to provide a twist of about 90° in the intermediate section which connects them, as shown in Figure 8.

**Claims**

1. A lead frame for providing compliant mechanical and electrical connections between an array type semiconductor package and a support surface in a surface mounting arrangement, said lead frame comprising a series of adjacent metallic terminal elements (10) each of which includes two spaced legs each having a bonding surface (14, 16), the legs being interconnected by a resilient intermediate section (17), and said lead frame further comprising break tabs (12) respectively interposed between and connected to the terminal elements (10) in said series so as to form an aligned strip (22) of terminal elements.

2. The lead frame of claim 1 wherein each of said break tabs (12) is connected to and oriented substantially at an angle to the intermediate sections (17) of the two adjacent terminal elements (10) to which it is connected.

3. The lead frame of claim 1 or 2 wherein each of said terminal elements (10) is generally C-shaped.

4. The lead frame of claim 1 or 2 wherein each of said terminal elements (10) is generally Z-shaped.

5. The lead frame of claim 1 or 2 wherein each of said terminal elements (10) is generally J-shaped.

6. The lead frame of any one of claims 1 to 5 wherein said terminal elements (10) and said break tabs (12) are integral, being formed from a single piece of metal.

7. The lead frame of any one of claims 1 to 6 wherein the intermediate section (17) of each terminal element (10) comprises a strip which has a twist about an axis perpendicular to said two bonding surfaces (14, 16).

8. The lead frame of claim 7 wherein said intermediate section (17) is twisted 90° about said perpendicular axis.

9. A method for attaching high compliance leads to an array type semiconductor package (18) for subsequent attachment to the surface of a printed circuit board, said method comprising the steps of:

forming a lead frame comprised of a strip (22) of adjacent terminal elements (10) connected in a side-by-side arrangement by means of break tabs (12) disposed between the terminal elements, each of the terminal elements (10) having a pair of spaced legs, resiliently interconnected by a resilient intermediate section (17) and each of the legs having a bonding surface (14, 16);

bonding one of the bonding surfaces (14, 16) of each of said terminal elements (10) to an associated bonding region (20) on the array type semiconductor package (18) while said terminal elements are connected in strip form; and

removing the break tabs (12) from the lead frame after said bonding step to thereby separate said terminal elements (10) from one another for subsequent attachment of the other mounting surface of each of said terminal elements to the surface of a printed circuit board.

10. The method of claim 9 wherein said forming step comprises shaping a single piece of metal into a series of alternating and integral terminal elements (10) and break tabs (12).

**Patentansprüche**

1. Ein Anschlußrahmen für nachgiebige mechanische und elektrische Verbindungen zwischen einem Halbleiter-Bauteil vom Matrix-Typ und einer Trägerfläche in einer Oberflächen-Montageanordnung, welcher Anschlußrahmen eine Serie benachbarter metallischer Anschlußelemente (10) umfaßt, von denen jedes zwei beabstandete Schenkel mit jeweils einer Anschlußfläche (14, 16) aufweist, die miteinander durch einen federnden Zwischenabschnitt (17) verbunden sind, und welcher Anschlußrahmen ferner Ausbrechzungen (12) umfaßt, die jeweils zwischen den Anschlußelementen (10) in der Reihe angeordnet und mit diesen verbunden sind, um so einen ausgefluchteten Streifen (22) von Anschlußelementen zu bilden.

2. Der Anschlußrahmen nach Anspruch 1, bei dem jede der Ausbrechzungen (12) mit den Zwischenabschnitten (17) der beiden benachbarten Anschlußelemente (10), mit denen sie verbunden ist, unter einem Winkel zu diesen orientiert verbunden ist.

3. Der Anschlußrahmen nach Anspruch 1 oder 2, bei dem jedes der Anschlußelemente allgemein C-förmig ist.

4. Der Anschlußrahmen nach Anspruch 1 oder 2, bei dem jedes der Anschlußelemente (10) allgemein Z-förmig ist.

5. Der Anschlußrahmen nach Anspruch 1 oder 2, bei dem jedes der Anschlußelemente (10) allgemein J-förmig ist.

6. Der Anschlußrahmen nach einem der Ansprüche 1 bis 5, bei dem die Anschlußelemente (10) und die Ausbrechzungen (12) einstückig sind, geformt aus einem einzigen Metallteil.

7. Der Anschlußrahmen nach einem der Ansprüche 1-6, bei dem der Zwischenabschnitt (17) jedes Anschlußelements (10) einen Streifen umfaßt, der um eine senkrecht zu den beiden Anschlußflächen (14, 16) verlaufende Achse tordiert ist.

8. Der Anschlußrahmen nach Anspruch 7, bei dem der Zwischenabschnitt (17) um die senkrechte Achse um 90° tordiert ist.

9. Ein Verfahren für das Anbringen von erheblich nachgiebigen Anschlüssen an einem Halbleiter-Bauteil (18) vom Matrix-Typ für die nachfolgende Befestigung an der Oberfläche einer gedruckten Schaltungskarte, welches Verfahren die Schritte umfaßt:

Bilden eines Anschlußrahmens, bestehend aus einem Streifen (22) aus benachbarten Anschlußelementen (10), die nebeneinander angeordnet mittels Ausbrechzungen (12) verbunden sind, die zwischen den Anschlußelementen angeordnet sind, wobei jedes Anschlußelement (10) ein Paar beabstandeter Schenkel aufweist, die federnd miteinander durch einen elastischen Zwischenabschnitt (17) verbunden sind und von denen jeder eine Anschlußfläche (14, 16) aufweist,

Verbinden einer der Anschlußflächen (14, 16) jedes Anschlußelements (10) mit einem zugeordneten Anschlußbereich (20) des Halbleiter-Bauteils (18) vom Matrix-Typ, während die Anschlußelemente in Streifenform verbunden sind, und

Entfernen der Ausbrechzungen (12) aus dem Anschlußrahmen nach dem Schritt des Verbindens, um dadurch die Anschlußelemente voneinander zu trennen für das nachfolgende Befestigen der anderen Anschlußfläche jedes der Anschlußelemente auf der Oberfläche der gedruckten Schaltungskarte.

10. Das Verfahren nach Anspruch 9, bei dem der Schritt des Bildens des Anschlußrahmens das Verformen eines einzigen Metallteils in eine Reihe alternierender und einstückiger Anschlußelemente (10) und Ausbrechzungen (12) umfaßt.

## Revendications

1. Ensemble de pattes permettant de réaliser des jonctions mécaniques et électriques à adaptation, réunissant um boîtier à semiconducteurs du typ en réseau et une surface de support faisant partie d'un agencement de montage en surface, cet ensemble de pattes comprenant une série de bornes métalliques adjacentes (10) dont chacune comporte deux branches espacées, chacume offrant une surface de jonction (14, 16), les branches étant rendues solidaires l'une de l'autre par une section intermédiaire élastique (17), et cet ensemble de pattes comprenant en outre des languettes à arracher (12) qui, respectivement, sont interposées entre les bornes (10) présentes dans la série et font l'objet d'une connexion avec ces bornes, de manière à constituer une bande aligée (22) de bornes.

2. Ensemble de pattes suivant la revendication 1, dans lequel chacune des languettes à arracher (12) est réunie, en étant orientée sensiblement sous un certain angle par rapport à elles, aux sections intermédiaires (17) des deux bornes (10) adjacentes dont elle est solidaire.

3. Ensemble de pattes suivant la revendication 1 ou 2, dans lequel chacune des bornes (10) est sensiblement en forme de C.

4. Ensemble de pattes suivant la revendication 1 ou 2, dans lequel chacune des bornes (10) est sensiblement en forme de Z.

5. Ensemble de pattes suivant la revendication 1 ou 2, dans lequel chacune des bornes (10) est sensiblement en forme de J.

6. Ensemble de pattes suivant l'une quelconque des revendications 1 à 5, das lequel les bornes (10) et les languettes à arracher (12) sont réalisées en une seule pièce, à partir d'un seul morceau de métal.

7. Ensemble de pattes suivant l'une quelconque des revendications 1 à 6, dans lequel la section intermédiaire (17) de chaque borne (10) est constituée par une bande qui présente une torsion autour d'un axe perpendiculaire aux deux surfaces de jonction (14, 16).

8. Ensemble de pattes de la revendication 7, dans lequel la section intermédiaire (17) fait l'objet d'une torsion de 90° autour dudit axe perpendiculaire.

9. Procédé permettant de fixer des pattes à adaptation élevée sur un boîtier à semi-conducteurs du type en réseau (18) en vue d'une fixation ultérieure sur la surface d'une plaquette à circuits imprimés, ce procédé consistant:

à former un ensemble de pattes constitué d'une bande (22) de bornes (10) adjacentes et réunies suivant une disposition côte àcôte à l'aide de languettes à arracher (12) disposées entre ces bornes, chacune des bornes (10) offrant une paire de branches espacées, réunies entre elles de manière élastique par une section intermédiaire élastique (17) et chacune de ces branches offrant une surface de jonction (14, 16),

à joindre l'une des surfaces de jonction (14, 16) de chacune des bornes (10) à une zone associée de jonction (20) située sur le boîtier à semi-conducteurs du type en réseau (18) pendant que ces bornes sont encore réunies sous forme de bande et

à ôter de l'ensemble de pattes les languettes à arracher (12) après l'opération de jonction, de façon à séparer ainsi les bornes (10) les unes des autres en vue d'une fixation ultérieure de l'autre surface de montage de chacune de ces bornes sur la surface d'une plaquette à circuits imprimés.

10. Procédé suivant la revendication 9, selon lequel l'opération de formage consiste à conformer un morceau unique de métal en une série de bornes (10) et de languettes à arracher (12) disposées de façon alternée et réalisées en une seule pièce.

*FIG.1*

*FIG.2*

*FIG.3*

*FIG.4*

*FIG.5*

*FIG.6*

*FIG.8*

*FIG.7*